# EUROPEAN PATENT APPLICATION

(11) **EP 3 567 639 A1**
(43) Date of publication of application: **13.11.2019**
(21) Application number: 18192919.1
(22) Date of filing: 06.09.2018
(51) Int. Cl.: H01L 31/049, H01L 31/048, H01L 31/18, B32B 17/10, H01L 31/0216, E04B 2/88, B32B 17/00, B32B 37/10

(54) **POWER GENERATION MECHANISM AND METHOD FOR MANUFACTURING THE SAME, POWER GENERATION APPARATUS**

(30) Priority: 08.05.2018 CN 201810433708; 08.05.2018 CN 201820682684 U; 08.05.2018 CN 201820677691 U
(71) Applicant: Beijing Hanergy Solar Power Investment Co., Ltd., 101499 Beijing (CN)
(72) Inventor: Wang, Chaoping, Beijing, 101499 (CN); Dai, Dongliang, Beijing, 101499 (CN); Liu, Dawai, Beijing, 101499 (CN); Chen, Dongchun, Beijing, 101499 (CN); Zhang, Xin, Beijing, 101499 (CN)
(74) Representative: Cohausz & Florack

(57) **Abstract**

A power generation mechanism, the power generation mechanism includes a light-transmitting front plate (1), a solar power generation unit (2) and a backplane protective plate (3), which are sequentially stacked together, wherein, the solar power generation unit (2) includes a reinforced substrate (201) and a solar cell (202) disposed on the reinforced substrate (201). The present disclosure further provides a method for manufacturing the power generation mechanism and a power generation apparatus.

## Description

### TECHNICAL FIELD

The present disclosure relates to but is not limited to a field of solar power generation technologies, and more particularly to, but is not limited to, a power generation mechanism and a method for manufacturing the same, a power generation apparatus.

### BACKGROUND

With the development of the economy, more and more transparent mechanisms or translucent mechanisms are applied to the field of architecture, such as laminated glass. Wherein, the laminated glass includes at least two pieces of glasses, an organic polymer adhesive layer disposed between the glasses, i.e. the laminated glass is a composite glass product of the glass and the adhesive layers. The laminated glass obtains a good mechanical strength through the coordinated action of the glass sheets and the adhesive layers.

Related techniques provide a laminated glass, the laminated glass includes: a glass front plate, an adhesive layer and a glass backplane which are laminated.

### SUMMARY

The following is an overview of the subject described in detail in present document. The present overview is not intended to limit the protection scope of protection.

The present disclosure provides the following technical solution:
One aspect, embodiments of the present disclosure provide a power generation mechanism, wherein, the power generation mechanism includes: a light-transmitting front plate, a solar power generation unit and a backplane protective plate, which are sequentially stacked together, wherein, the solar power generation unit includes a reinforced substrate and a solar cell disposed on the reinforced substrate.

Optionally, the solar cell is embedded into the reinforced substrate; or, the solar cell is disposed on a surface of the reinforced substrate.

Optionally, on a condition that the solar cell is embedded into the reinforced substrate, a surface of the solar cell is flush with a surface of the reinforced substrate.

Optionally, a side surface of the reinforced substrate facing the light-transmitting front plate and a side surface of the reinforced substrate facing the backplane protective plate are both provided with the solar cell, and the backplane protective plate is a light-transmitting backplane.

Optionally, the power generation mechanism further includes an insulation antireflection film disposed on the light-transmitting front plate.

Optionally, the power generation mechanism further includes an insulation antireflection film disposed on the light-transmitting front plate and/or the light-transmitting backplane

Optionally, the power generation mechanism further includes an insulation sealing layer disposed between the light-transmitting front plate and the solar power generation unit.

Optionally, the power generation mechanism further includes a first adhesive layer disposed between the light-transmitting front plate and the solar power generation unit; and/or, a second adhesive layer disposed between the backplane protective plate and the solar power generation unit, wherein, the first adhesive layer is a colored adhesive film, and the light-transmitting front plate is a transparent front plate.

Optionally, the light-transmitting front plate is a colored light-transmitting front plate; or a color film layer is provided on a plate surface of the light-transmitting front plate.

Optionally, a thickness of the light-transmitting front plate and a thickness of the backplane protective plate are both larger than a thickness of the reinforced substrate, and /or an intensity of the light-transmitting front plate and an intensity of the backplane protective plate are both greater than an intensity of the reinforced substrate.

Another aspect, embodiments of the present disclosure provide a method for manufacturing any one of the above power generation mechanisms, wherein, the method includes: laminating a light-transmitting front plate, a solar power generation unit, a backplane protective plate, which are sequentially stacked together, to form the power generation mechanism.

Optionally, laminating the light-transmitting front plate, the solar power generation unit, the backplane protective plate, which are sequentially stacked together, to form the power generation mechanism, includes: sequentially stacking the light-transmitting front plate, a first adhesive layer, the solar power generation unit, a second adhesive layer and the backplane protective plate; pre-exhausting and pre-heating the light-transmitting front plate, the first adhesive layer, the solar power generation unit, the second adhesive layer and the backplane protective plate, which are sequentially stacked together, to form an in-process product; exhausting and heating the in-process product to form the power generation mechanism.

Optionally, the pre-exhausting includes a first pressurized operation and/or, a first vacuum pumping operation; the exhausting includes a second pressurized operation and/or, a second vacuum pumping operation, wherein, a pressure of the first pressurized operation is smaller than a pressure of the second pressurized operation; a suction force corresponding to the first vacuum pumping operation is smaller than a suction force corresponding to the second vacuum pumping operation.

Optionally, before laminating the light-transmitting front plate, the solar power generation unit and the backplane protective plate, which are sequentially stacked together, the method further includes: providing an insulation sealing layer between the light-transmitting front plate and the solar power generation unit.

Yet another aspect, embodiments of the present disclosure provide a power generation apparatus comprising at least one of the above power generation mechanisms.

### BRIEF DESCRIPTION OF THE DRAWINGS

The accompanying drawings are used to provide further understanding of the disclosure and constitute a part of the description. The accompanying drawings together with the following embodiments serve to explain the disclosure, but do not constitute a limitation to the disclosure. In the accompanying drawings:
Fig. 1A is a structural schematic diagram of a power generation mechanism provided by some embodiments of the present disclosure;
Fig. 1B is a exploded view of a power generation mechanism provided by some embodiments of the present disclosure;
Fig. 2A is a schematic diagram of a position relationship between a reinforced substrate and a solar cell provided by some embodiments of the present disclosure;
Fig. 2B is a schematic diagram of a second position relationship between another reinforced substrate and a solar cell provided by some embodiments of the present disclosure;
Fig. 3A is a first structural schematic diagram of another power generation mechanism provided by some embodiments of the present disclosure;
Fig. 3B is a second structural schematic diagram of a yet another power generation mechanism provided by some embodiments of the present disclosure;
Fig. 3C is a third structural schematic diagram of a still another power generation mechanism provided by some embodiments of the present disclosure;
Fig. 3D is a fourth structural schematic diagram of a yet still another power generation mechanism provided by some embodiments of the present disclosure;
Fig. 3E is a fifth structural schematic diagram of a yet still another power generation mechanism provided by some embodiments of the present disclosure;
Fig. 3F is a sixth structural schematic diagram of a yet still another power generation mechanism provided by some embodiments of the present disclosure;
Fig. 4 is a structural schematic diagram of a solar power generation unit provided by some embodiments of the present disclosure;
Fig. 5 is a schematic diagram of a position relation among an insulation sealing layer, a bus bar and a solar cell provided by some embodiments of the present disclosure;
Fig. 6 is a flow chart of a method for manufacturing a power generation mechanism provided by some embodiments of the present disclosure; and
Fig. 7 is a flow chart of another method for manufacturing power generation mechanism provided by some embodiments of the present disclosure.

### DETAILED DESCRIPTION

In some related technologies, light, such as the sunlight, may directly penetrate a laminated glass, and the light energy cannot be utilized.

In some other related technologies, a solar photoelectric curtain wall is a green decorative wall integrating curtain wall characteristics and power generation functions, and may directly utilize the sunlight to generate power, so green non-polluting, and without producing any greenhouse gases.

At present, the solar photoelectric curtain wall includes a glass curtain wall, and a solar cell chip bonded on a surface of the glass curtain wall by an adhesive sheet. but since the solar cell chip adopts an ordinary glass backplane, when the solar cell chip is applied to the solar photoelectric curtain wall, the glass backplane used in the solar cell chip is easily broken during the process of testing the impact resistance for the solar cell chip, and due to the poor bonding performance of the adhesive sheet to the glass backplane which is used in the solar cell chip, the glass back sheet fragments fall down easily, such that the solar photoelectric curtain wall has safety hazards.

The technical solutions in some embodiments of the present disclosure will be described clearly and completely with reference to the accompanying drawings in some embodiments of the present disclosure. Obviously, the described embodiments are merely some but not all embodiments of the present disclosure. All other embodiments made on the basis of the embodiments of the present disclosure by a person of ordinary skill in the art shall be included in the protection scope of the present disclosure.

Unless otherwise defined, all technical terms used in the embodiments of the present disclosure have the same meaning as commonly understood by those skilled in the art. For clearer purposes, technical solutions and advantages of the embodiments of the disclosure will be described below in detail with reference to the accompanying drawings.

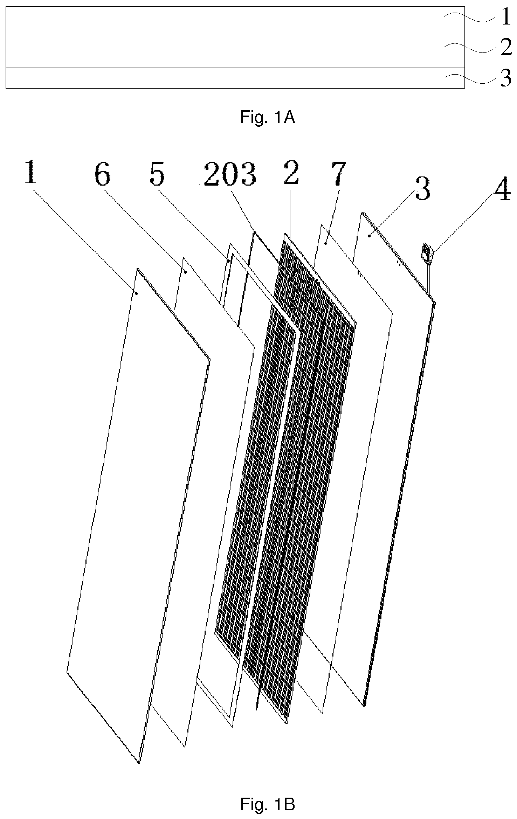

One aspect, some embodiments of the present disclosure provide a power generation mechanism, as shown in Figs. 1A and 1B, the power generation mechanism includes a light-transmitting front plate 1, a solar power generation unit 2, and a backplane protective plate 3, which are sequentially stacked together.

It will be noted that, the aforementioned light-transmitting front plate 1 may also be called as a light-transmitting front protective plate, the aforementioned solar power generation unit 2 may also be called as a solar cell chip and the aforementioned backplane protective plate 3 may also be called as a backplane. The aforementioned power generation mechanism may be exemplary a solar cell module or a photoelectric cell glass.

The power generation mechanism provided by the embodiments of the present disclosure can convert luminous energy that penetrates into the power generation mechanism to electric energy by disposing the solar power generation unit 2, thereby providing clean electrical energy. Compared with the transparent mechanism and the translucent mechanism, the competitiveness and the economic suitability performance of the products are improved.

In addition, when the aforementioned power generation mechanism is applied to the glass curtain wall, even if the power generation mechanism was hit, the solar power generation unit 2 in the middle could be protected by the light-transmitting front plate 1 and the backplane protective plate 3, thereby reducing the risk of the breakage of the solar power generation unit 2 to decrease the occurrence of unsafe accidents.

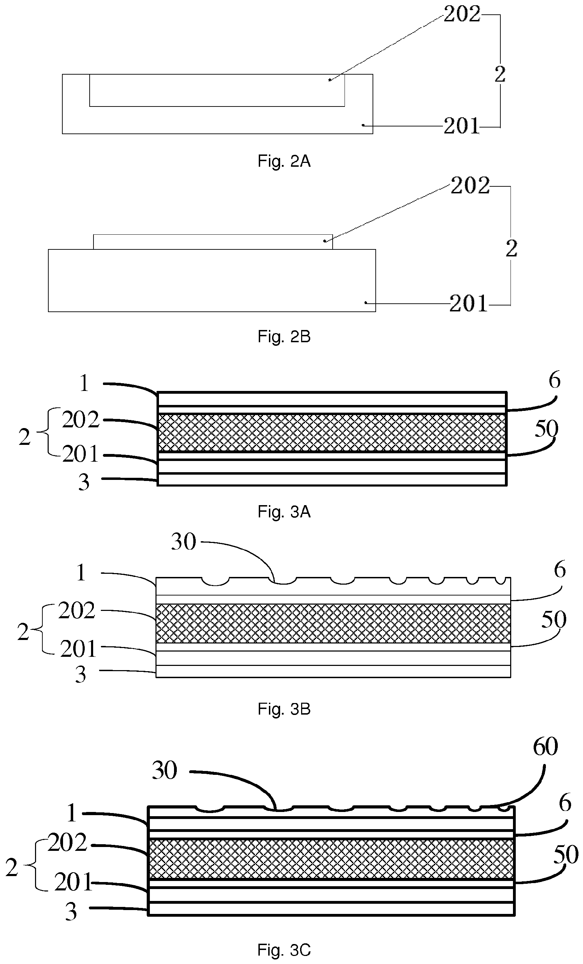

In some embodiments, as shown in Figs. 2A-3F, the aforementioned solar power generation unit 2 includes a reinforced substrate 201, and a solar cell 202 disposed on the reinforced substrate 201.

It will be noted that, the reinforced substrate 201 can be used as a backplane of the solar cell 202 in the solar power generation unit 2, the backplane protective plate 3 can be used to protect the reinforced substrate 201 to avoid the breakage of the reinforced substrate 201. The aforementioned solar cell 202 can be a battery functional layer.

Wherein, the light incident surface of the solar cell 202 is disposed towards the light-transmitting front plate 1 to ensure that light can penetrate the transparent front plate 1 and irradiate onto the solar cell 202.

Through disposing the solar cell 202 on the reinforced substrate 201, and making the reinforced substrate 201 and the solar cell 202 being formed as an overall structure, the mechanical strength of the solar power generation unit 2 is improved, thereby improving the mechanical strength and safe application performance of the power generation mechanism, and prolonging the service life of the power generation mechanism.

For example: in the related technologies, due to the falling of the backplane fragments for fixing the solar cell, pedestrians are injured. Or since the backplane for fixing the solar cell are broken or cracked, the air enters into the solar cell, so that when the solar cell is in the power generation state, it is easy to generate heat and result in a fire.

While the aforesaid power generation mechanism provided by the embodiments of the present disclosure are adopted, when the power generation mechanism is applied to a building based on building integrated photovoltaic, such as glass curtain wall, the risk of the breakage of the backplane for fixing the solar cell may be reduced to decrease the occurrence of unsafe accidents.

In some embodiments of the present disclosure, there are various connection manners between the light-transmitting front plate 1 and the solar power generation unit 2, and between the backplane protective plate 3 and the solar power generation unit 2. Under the premise of considering of simple preparation process and good connection strength, referring to Fig. 1B, the light-transmitting front plate 1 can be connected to the solar power generation unit 2 through a first adhesive layer 6, the backplane protective plate 3 can be connected to the solar power generation unit 2 through a second adhesive layer 7.

Herein, the first adhesive layer can also be called as a first adhesive film, and the second adhesive layer can also be called as a second adhesive film.

In some embodiments of the present disclosure, there are various position relationships between the solar cell 202 and the reinforced substrate 201, under the premise of easy manufacturing, the following examples are given:

The solar cell 202 is embedded into the reinforced substrate 201, and a surface of solar cell 202 is flush with a surface of the reinforced substrate 201, referring to Fig. 2A. Or, the solar cell 202 is disposed on a surface of the reinforced substrate 201, referring to Fig. 2B.

Herein, referring to Fig. 2A, the aforementioned "the solar cell 202 is embedded into the reinforced substrate 201 "means that a part of a surface of the reinforced substrate 201 forms an inwardly groove, and the groove is used to receive the solar cell 202. The aforementioned "a surface of solar cell 202 is flush with the surface of the reinforced substrate 201 "means that the remaining part of the surface of the reinforced substrate 201 formed with the groove is flush with the surface of the solar cell 202.

It is easy to realize the aforementioned two position relationships between the solar cell 202 and the reinforced substrate 201. And when the solar cell 202 is embedded into the reinforced substrate 201, the reinforced substrate 201 plays a role in protecting the solar cell 202.

In order to enlarge the application range and improve the generating efficiency of the power generation mechanism, as an example, the two side surfaces of the reinforced substrate 201 facing the transparent front plate 1 and the backplane protective plate 3 respectively are both provided with the solar cell 202, that is, the solar power generation unit 2 can generate electricity on the two side surfaces. At this moment, the backplane protective plate 3 is a light-transmitting backplane 3, wherein, between the reinforced substrate 201 and the light-transmitting backplane 3, a light incident surface of the solar cell 202 is disposed towards the light-transmitting backplane 3 to facilitate the penetration of light. There are various methods in which the solar cell 202 is disposed on the reinforced substrate 201, so long as the reinforced substrate 201 and the solar cell 202 are formed as an overall structure.

As an example, the solar cell 202 is manufactured by forming a photoelectric conversion material on the reinforced substrate 201 by a sputtering process or a vapor deposition process.

By the sputtering process or the vapor deposition process, the connection force between the solar cell 202 and the reinforced substrate 201 is good, which is beneficial to form the solar cell 202 and the reinforced substrate 201 as an overall structure and convenient to the production of the power generation mechanism.

As another example, referring to Figs. 3A-3F, the light-transmitting front plate 1 and the light incident surface of the solar cell 202 are bonded together through a first adhesive layer 6, the solar cell 202 and the reinforced substrate 201 may be also bonded together through a second adhesive layer 7 to further ensure the connection strength between the solar cell 202 and the reinforced substrate 201.

In above two examples, the photoelectric conversion material for preparing the solar cell 202 may be copper indium gallium selenium, cadmium telluride, and gallium arsenide.

In the embodiments of the present disclosure, when the solar cell 202 is prepared by forming the photoelectric conversion material on the reinforced substrate 201 by the sputtering process or the vapor deposition process, considering that the material of the reinforced substrate 201 should be matched with the sputtering process or the vapor deposition process, the material of the reinforced substrate 201 may be non-tempered glass. For example, the material of the reinforced substrate 201 may be a float glass.

The reinforced substrate 201 with the aforementioned materials can not only improve the mechanical strength of the solar power generation unit 2, but also facilitate the solar power generation unit 2, the light-transmitting front plate 1 and the backplane protective plate 3 (exemplary, it may be a light-transmitting backplane) to form a power generation mechanism having glass properties, the power generation mechanism can apply to different fields, such as the architecture field.

When the materials of the light-transmitting front plate 1 and the backplane protective plate 3 are both glass, and when the material of the reinforced substrate 201 is non-tempered glass, the power generation mechanism has a mirror effect, which facilitates decoration.

As an example, the solar cell 202 is black (or dark color), and when the solar cell 202 is disposed on a side of the reinforced substrate 201 facing towards the light-transmitting front plate 1, the side of the solar power generation unit 2 facing the light-transmitting front plate 1 is black, and the opposite side has a mirror effect.

That is, the solar cell is similar to a covering layer of the back of a mirror, and the reinforced substrate 201 is similar to a mirror plane. When the power generation mechanism is used as the glass of windows, the backplane protective plate 3 of the power generation mechanism may be located indoors. Since the material of the backplane protective plate 3 is glass, the power generation mechanism has the mirror effect indoors, thereby improving the aesthetics of the construction outdoors, meanwhile improving the brightness indoors.

In order to make the light easily penetrate into the power generation mechanism to facilitate power generation, as an example, the power generation mechanism provided by some embodiments of the present disclosure further includes an insulation antireflection film disposed on the light-transmitting front plate 1.

More light is able to penetrate into the light-transmitting front plate 1 to be received by the solar cell 202 by disposing the insulation antireflection film.

Wherein, the insulation antireflection film is also called as an insulation anti-reflection film, material of which can be a titanium dioxide or a zirconia. The insulation antireflection film with one of the two materials not only increases the transmittance of the light, but also has alkali resistance and waterproof and moisture resistance.

The insulation antireflection film can be formed on the light-transmitting front plate 1 through the sputtering process or the vapor deposition process.

When the solar power generation unit 2 generates power on two side surfaces, the light-transmitting backplane 3 can be also provided with an insulation antireflection film.

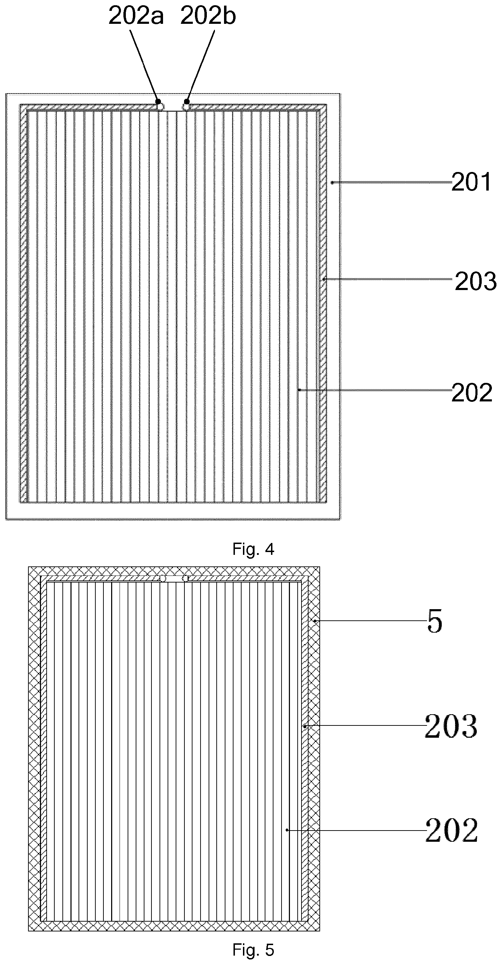

Considering of using the power generated by the solar power generation unit 2 conveniently, as shown in Fig. 4, the solar power generation unit 2 further includes a bus bar 203 electrically connected with the solar cell 202.

Referring to Fig. 4, the amount of the bus bar 203 can be two, and the two bus bars 203 are connected to the anode 202a and the cathode 202b of the solar cell 202 respectively. The bus bar 203 can be welded connected to the solar cell 202, and also be cohesive connected to the solar cell 202.

It will be noted that, in Fig. 4, the positions of the anode 202a and the cathode 202b of the solar cell 202 are only illustrative, and do not constitute a limitation on the position between the anode and the cathode of the solar cell 202.

Wherein, the bus bar 203 may be a copper strip, the copper strip has good conducting properties, and is easy to obtain.

As an example, the width of the bus bar 203 may be exemplary 2∼10 mm, such as 2 mm, 3 mm, 4 mm, 5 mm, 6 mm, 7 mm, 8 mm, 9 mm, or 10 mm etc.

The thickness of the bus bar may be exemplary 0.1∼0.3mm, such as 0.1 mm, 0.2 mm or 0.3 mm etc.

In order to make the bus bar 203 be welded connected to the solar cell 202 easily, and to increase the conducting properties of the bus bar 203, the bus bar 203 can be electrically connected with the solar cell 202 through a conductive connector.

For example, or, the conductive connector may be a tin layer disposed on a surface of the bus bar 203, the tin layer not only has conducting properties, but also facilitates the welded connection between the bus bar 203 and the solar cell 202, in addition, the tin layer further has an oxidation resistance.

Or, the conductive connector may also be a silver layer disposed on the surface of the bus bar 203, the silver layer has good conducting properties, and thereby increasing the conducting properties between the bus bar 203 and the solar cell 202. The silver layer further has an oxidation resistance.

The thickness of the tin layer or the silver layer may be exemplary 0.01∼0.05mm, such as 0.01 mm, 0.02 mm, 0.03 mm, 0.04 mm, or 0.05 mm etc.

Considering that the external machinery equipment is expected to easily use the electric energy generated by the power generation mechanism provided by some embodiments of the present disclosure, as shown in Fig. 1B, the power generation mechanism provided by some embodiments of the present disclosure further includes a junction box 4 electrically connected to the bus bar 203.

Wires are provided in the junction box 4, so that the bus bar 203 and the external machinery equipment are all electrically connected with the junction box 4, so that the power generation mechanism supplies power to the external machinery equipment.

As an example, the junction box 4 is disposed on the backplane protective plate 3, the reinforced substrate 201 and backplane protective plate 3 may be both provided with via holes, an end of the bus bar 203 is led out by the via hole and electrically connected to the junction box 4.

In order to prevent impurities, such as external moisture, dust, from entering into the area between the light-transmitting front plate 1 and the backplane protective plate 3 to affect the power generation performance of the solar power generation unit 2, as shown in Fig. 1B, the power generation mechanism further includes an insulation sealing layer 5 disposed between the light-transmitting front plate 1 and the solar power generation unit 2.

As an example, the insulation sealing layer 5 is disposed on the periphery between the light-transmitting front plate 1 and the solar cell 202 (i.e. rectangular ring). Referring to Fig. 5, the external moisture and dust are prevented from entering into the area between the light-transmitting front plate 1 and the backplane protective plate 3 through the arrangement of the insulating sealing layer 5.

Wherein, the material of the insulation sealing layer 5 may be exemplary a butyl rubber tape, a silica gel etc.

As an example, the width of the insulation sealing layer 5 may be exemplary 6∼12mm, such as 6 mm, 7 mm, 8 mm, 9 mm, 10 mm, 11 mm or 12 mm etc.

As an example, the thickness of the insulation sealing layer 5 may be exemplary 0.8∼1.8mm, such as 0.8 mm, 0.9 mm, 1 mm, 1.1 mm, 1.2 mm, 1.3 mm, 1.4 mm, 1.5 mm, 1.6 mm, 1.7 mm or 1.8 mm etc.

The application field of the power generation mechanism provided by some embodiments of the present disclosure is wide, for example, the aforementioned power generation mechanism is used in the architecture field. Therefore, considering of improving the mechanical strength of the power generation mechanism to suit different application fields, the power generation mechanism includes one or more layers of light-transmitting front plates 1; and/or, the power generation mechanism includes one or more layers of the backplane protective plates 3.

That is, the light-transmitting front plate 1 and the backplane protective plate 3 are both provided as one layer.

Or, the light-transmitting front plate 1 is provided as one layer, and the backplane protective plate 3 is provided as a plurality of layers.

Or, the light-transmitting front plate 1 is provided as a plurality of layers, and the backplane protective plate 3 is provided as one layer.

Or, the light-transmitting front plate 1 and the backplane protective plate 3 are both provided as a plurality of layers.

When the light-transmitting front plate 1 is provided as the plurality of layers, and/or, the backplane protective plate 3 is provided as the plurality of layers, the mechanical strength of the power generation mechanism may be increased.

When the light-transmitting front plate 1 and the backplane protective plate 3 are provided as the plurality of layers, there are various connection methods between two adjacent light-transmitting front plates 1, the following two examples are provided under the premise of easy connection:
As a first example: the two adjacent light-transmitting front plates 1 can be connected through the third adhesive layer, the two adjacent backplane protective plates 3 can be connected through a fourth adhesive layer.

The connection method adopting the third adhesive layer and the fourth adhesive layer is simple, and the connection strength is good.

As a second example: the two adjacent light-transmitting front plates 1 are connected by a way of clamping connection, and the adjacent two backplane protective plates 3 are also connected by a way of clamping connection.

The method of the clamping connection is simple, and facilitates the disassembly between the two adjacent light-transmitting front plates 1, and the disassembly between the adjacent two backplane protective plates 3.

Taking the two adjacent light-transmitting front plates 1 being the clamping connection as an example, a clamping groove is provided on one layer of light-transmitting front plate 1, and a clamping component is provided on another layer of the light-transmitting front plate 1. The two adjacent light-transmitting front plates 1 are connected by making the clamping component clip into the clamping groove. The two adjacent light-transmitting front plates 1 are disassembled by separating the clamping component from the clamping groove.

The structures of the clamping component and the clamping groove will not be limited, as long as they satisfy the clamping connection.

In order to improve the mechanical strength of the light-transmitting front plate 1 and the backplane protective plate 3, the materials of the light-transmitting front plate 1 and the backplane protective plate 3 can be tempered glass, semi-tempered glass, or float glass.

When both the materials of the light-transmitting front plate 1 and the backplane protective plate 3 are tempered glasses or semi-tempered glass, the light-transmitting front plate 1, the backplane protective plate 3 and the power generation mechanism have good mechanical strength.

In addition, when both the materials of the light-transmitting front plate 1 and the backplane protective plate 3 are glass, and when the material of the reinforced substrate 201 is glass, the power generation mechanism has a mirror effect, and facilitates its decorative effect in the field of architecture.

For example, the materials of the light-transmitting front plate 1 and the backplane protective plate 3 may be any one of an ultra-clear tempered glass, an ordinary tempered glass, and the semi-tempered glass.

Wherein, the ultra-clear tempered glass has the advantages of crystal clear, high mechanical strength, low self-explosion rate, so it facilitates the decoration, the improvement of the mechanical strength and the decoration performance of the power generation mechanism, and prolongs its service life.

The ordinary tempered glass has the advantages of low cost and high mechanical strength, so it is beneficial to improve the mechanical strength of the power generation mechanism.

In some embodiments of the present disclosure, the materials of the first adhesive layer 6, the second adhesive layer 7, the third adhesive layer, and the fourth adhesive layer may be any one of a polyethylene vinylacetate (EVA) adhesive, a color polyvinyl butyral (PVB) adhesive, and a polyolyaltha olfin (POE) adhesive.

In practical applications, different colors of the first adhesive layer 6, the second adhesive layer 7, the third adhesive layer and the fourth adhesive layer can be selected according to a specific usage requirements to meet the decorative requirements of the power generating mechanism.

As an example, the thickness of the light-transmitting front plate 1 may be 3 mm∼10 mm, such as 3 mm, 4 mm, 5 mm, 6 mm, 7 mm, 8 mm, 9 mm or 10 mm etc.

The thickness of the first adhesive layer 6 may be exemplary 0.2∼2mm, such as 0.2 mm, 0.5 mm, 0.76 mm, 0.9 mm, 1.2 mm, 1.52 mm, 1.7 mm, 1.9 mm or 2 mm etc.

The thickness of the second adhesive layer 7 may be exemplary 0.2∼2mm, such as 0.2 mm, 0.5 mm, 0.76 mm, 0.9 mm, 1.14 mm, 1.52 mm, 1.7 mm, 1.9 mm or 2 mm etc.

The thickness of the backplane protective plate 3 maybe exemplary 3∼10mm, such as 3 mm, 4 mm, 5 mm, 6 mm, 7 mm, 8 mm, 9 mm or 10 mm etc.

The power generation mechanisms with the above dimensions are widely used, and have good decorative effects.

In some embodiments of the present disclosure, in order to achieve the protection for the reinforced substrate 201 (i.e. as the backplane of the solar cell 202), which is in the solar power generation unit 2 and is provided with the solar cell 202, by the backplane protective plate 3 and the light-transmitting front plate 1 (such as the light-transmitting front plate protective plate), it can be implemented by, for example, but not limited to, the following ways.

A first method: the strength of the light-transmitting front plate 1 and the strength of the backplane protective plate 3 are both higher than the strength of the reinforced substrate 201 through selecting the type of the materials of the light-transmitting front plate 1, the backplane protective plate 3 and the reinforced substrate 201, thereby achieving the purpose of protecting the reinforced substrate 201 by using the light-transmitting front plate 1 and the backplane protective plate 3.

For example: the reinforced substrate 201 is generally the ordinary glass, in some embodiments of the present disclosure, the materials of the light-transmitting front plate 1 and the backplane protective plate 3 can select the tempered glass, so that the strength of the light-transmitting front plate 1 and the strength of the backplane protective plate 3 are both higher than the strength of the reinforced substrate 201.

In addition, the light-transmitting front plate 1 and the backplane protective plate 3 may be exemplary an elastic substrate. The impact force of the power generating mechanism (for example, a solar cell module) is buffered by the elastic properties of the elastic substrate, so that the strength of the light-transmitting front plate 1 and the strength of the backplane protective plate 3 are both higher than the strength of the reinforced substrate 201. Under the circumstances, the light-transmitting front plate 1 and the backplane protective plate 3 can buffer the impact force by using the elastic action to achieve the purpose of protecting the reinforced substrate 201.

Herein, it should be noted that, at least the elastic substrate served as the light-transmitting front plate 1 needs to be transparent or light-transmitting to ensure that the sunlight is able to penetrate the light-transmitting front plate 1 and irradiate on the solar cell 202.

Wherein, the light-transmitting elastic substrate is a light-transmitting elastic substrate made of a polyurethane material or a light-transmitting substrate made of an ethylene acrylic acid copolymer.

Considering that when the strength of the light-transmitting front plate 1 is different from the strength of the backplane protective plate 3, the protection effort for the reinforced substrate 201 by the light-transmitting front plate 1 is different from the protection effort for the reinforced substrate 201 by the backplane protective plate 3, so that the reinforced substrate 201 is easy to be broken due to the nonuniform force. Based on this, in the embodiments provided by the present disclosure, the strength of the light-transmitting front plate 1 is the same with the strength of the backplane protective plate 3.

For example: When the materials of the light-transmitting front plate 1 and the backplane protective plate 3 are tempered glass, the thickness of the light-transmitting front plate 1 is the same with the thickness of the backplane protective plate 3.

When the light-transmitting front plate 1 and the backplane protective plate 3 are both elastic substrate, based on that the used materials of the light-transmitting front plate 1 and the backplane protective plate 3 are the same elastic materials, it should be ensured that the thickness of the light-transmitting front plate 1 is the same with the thickness of the backplane protective plate 3.

The second method: the same type of the light-transmitting front plate 1, the backplane protective plate 3 and the reinforced substrate 201 can be selected, based on this, the thickness of the light-transmitting front plate 1 and the thickness of the backplane protective plate 3 are both larger than the thickness of the reinforced substrate 201, so that both the light-transmitting front plate 1 and the backplane protective plate 3 have high strength.

For example: when the materials of the light-transmitting front plate 1, the backplane protective plate 3, and the reinforced substrate 201 are all ordinary glass, the thickness of the light-transmitting front plate 1 and the thickness of the backplane protective plate 3 may be larger than the thickness of the reinforced substrate 201.

It will be noted that, the power generation mechanism (such as a solar cell module) provided by some embodiments of the present disclosure may be a component of an opaque color derivative series, a component of an opaque stone pattern derivative series, a component of a light-transmitting color glass plate derivative series or a component of a light-transmitting hollow sound and thermal insulation derivative series. The following are described as examples.
exemplary, in order to apply the power generation mechanism (such as a solar cell module) provided by some embodiments of the present disclosure to a building based on building integrated photovoltaic, such as the glass curtain wall, referring to Figs. 3B and 3C, the surface of the building based on building integrated photovoltaic generally has a decorative texture layer, the texture of the decorative texture layer can be stone texture, wood fiber texture, or decorative pit texture. the plate surface of the aforementioned light-transmitting front plate 1 provided by some embodiments of the present disclosure can be provided with decorative texture layer, the decorative texture layer not only has a decorative effect, but also can scatter the sunlight to reduce the light brightness reflected by the solar cell module applied to the building based on building integrated photovoltaic, thereby alleviating the glare problems.

When specially implemented, the power generation mechanism (such as a solar power generation component) provided by some embodiments of the present disclosure can provide decorative texture layer on the surface of the building based on building integrated photovoltaic by, but not limited to, the following two methods.

The first method: referring to Fig. 3B, the decorative texture layer in some embodiments of the present disclosure is a decorative pattern 30 disposed on the plate surface of the light-transmitting front plate 1 by a process such as etching or the like.

Herein, through etching the decorative pattern 30 on the plate surface of the light-transmitting front plate 1, not only the decorative effect is achieved and the glare is alleviated, but also the overall weight of the power generation mechanism (such as a solar power generation component) is reduced, so that the aforementioned power generation mechanism (such as a solar power generation component) is easier to satisfy the lightweight requirement of the building based on building based on building integrated photovoltaic.

The second method: referring to Fig. 3C, in some embodiments of the present disclosure, the decorative texture layer is a texture film layer 60 disposed on the plate surface of the light-transmitting front plate 1, the texture film layer 60 can be a texture adhesive film, an ordinary texture thin film, or a coating film layer. The texture of the texture film layer 60 can run through the whole texture film layer 60, or cannot run through the whole texture film layer 60, or may be a pattern disposed on the texture film layer 60. So that when the power generation mechanism (such as a solar power generation component) is applied to the building based on building integrated photovoltaic, the aforementioned power generation mechanism (such as a solar power generation component) may not only generate photovoltaic power, but also, as the decorative materials, be applied to the building based on building integrated photovoltaic .

Furthermore, referring to Figs. 3B and 3C, some embodiments of the present disclosure consider that the decorative texture layer may realize the purpose of anti-glare, therefore the decorative texture layer provided by some embodiments of the present disclosure is disposed on the surface of the light-transmitting front plate 1 deviated from the solar cell 202.

Exemplary, in order to diversify the exterior color of the building based on building integrated photovoltaic when the power generation mechanism (such as a solar power generation component) provided by some embodiments of the present disclosure is applied to the building based on building integrated photovoltaic, such as glass curtain wall, the power generation mechanism (such as a solar power generation component) provided by some embodiments of the present disclosure may adopt, but not limit to, the following three methods to realize the diversification of the exterior color of the building based on building integrated photovoltaic.

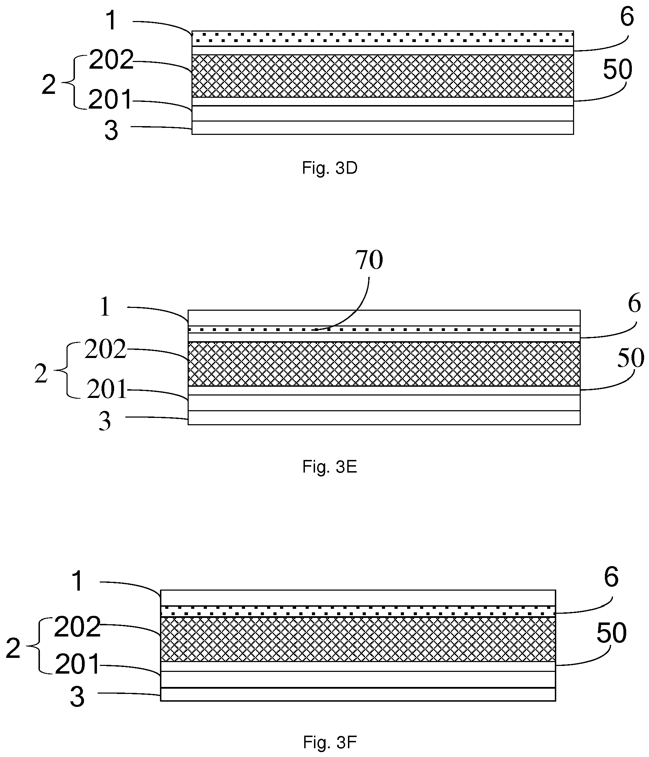

The first method: referring to Fig. 3D, the light-transmitting front plate 1 is a color front plate protective plate to realize the diversification of the exterior color of the building based on building integrated photovoltaic.

The second method: referring to Fig. 3E, a color film layer 70 is formed on the plate surface of the light-transmitting front plate 1 (the color film layer 70 may be at least one reflective coating film layer which is shown in color as a whole, or a color coating film layer), so that the exterior color of the building based on building integrated photovoltaic is diversified. The reflective coating film layer is covered on the light-transmitting front plate 1, and is shown in color. The sunlight irradiates onto the reflective coating film layer, and is reflected by the reflective coating film layer, so that the light-transmitting front plate 1 is shown in color visual effect. The reflective coating film layer can be coated on the light-transmitting front plate 1 in a method such as electroplating or magnetron sputtering. The material of the reflective coating film layer (such as titanium) may be provided according to the requirements, so long as it can realize the color effect of the light-transmitting front plate 1. The color coating film can be bonded to the light-transmitting front plate 1 by an adhesive, the color coating film layer makes the light-transmitting front panel 1 to be shown in color due to its own color. The material of the color coating film layer (such as a plastic film with colors) can be also provided according to the requirements, so long as it can realize the color effect of the light-transmitting front plate 1.

For the second method, since the color film layer 70 is long-term exposed to the outside, it is prone to generate undesirable problems, such as fading etc., in this way, the color film layer 70 may be exemplary formed on the surface of the light-transmitting front plate 1 facing the solar cell 202 to protect the color film layer 70.

The third method: referring to Fig. 3F, in some embodiments of the present disclosure, when the light-transmitting front plate 1 and the light incident surface of the solar cell 202 are bonded together through the first adhesive layer 6, under this circumstance, the first adhesive layer 6 may be provided as a color light-transmitting adhesive film, so that the light-transmitting front plate 1 is bonded to the incident surface of the solar cell 202 by the first adhesive layer 6, while the exterior colors of the building based on building integrated photovoltaic are diversified.

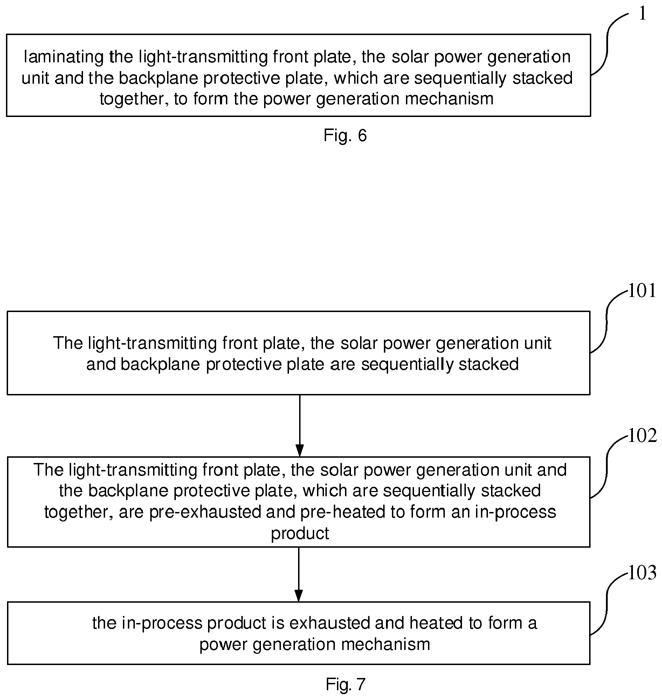

When the power generation mechanism (such as a solar power generation component) obtained based on the aforementioned three methods is applied to the building based on building integrated photovoltaic such as the glass curtain wall, the building based on building integrated photovoltaic has a beautiful appearance, and compared to the conventional building based on building integrated photovoltaic, the power generation mechanism provided by the embodiments of the present disclosure can reduce light brightness irradiated onto the solar power generation unit 2 by disposing the colored light-transmitting front plate 1, and/or color film layer 70, and/or colored adhesive film, thereby further protecting the solar cell 202 in the solar power generation unit 2 from the loss of service life of the solar cell 202 due to excessive light. In another aspect, some embodiments of the present disclosure further provide a method for manufacturing any one of the above mentioned power generation mechanism, as shown in Fig. 6, the method includes:
Step 1, a light-transmitting front plate 1, a solar power generation unit 2 and a backplane protective plate 3, which are sequentially stacked together, are laminated to form a power generation mechanism. The above method is simple, and facilitates the production of the power generation mechanism.

Wherein, the solar power generation unit 2 includes a reinforced substrate 201, a solar cell 202 disposed on the reinforced substrate 201.

As an example, as shown in Fig. 7, the step 1 includes Steps 101-103.

Step 101, the light-transmitting front plate 1, the solar power generation unit 2 and backplane protective plate 3 are sequentially stacked.

Step 102, the light-transmitting front plate 1, the solar power generation unit 2 and the backplane protective plate 3, which are sequentially stacked together, are pre-exhausted and pre-heated to form an in-process product;

Step 103, the in-process product is exhausted and heated to form a power generation mechanism.

It will be noted that, when the light-transmitting front plate 1 is connected to the solar power generation unit 2 through the first adhesive layer 6, and the solar power generation unit 2 is connected to the backplane protective plate 3 through the second adhesive layer 7, during the process of pre-exhausting, pre-heating, exhausting, and heating, there are gaps for exhausting between the first adhesive layer 6 and the light-transmitting front plate 1, between the first adhesive layer 6 and the solar power generation unit 2, between the second adhesive layer 7 and the solar power generation unit 2, and between the second adhesive layer 7 and the backplane protective plate 3.

The above method is simple, the gases among the light-transmitting front plate 1, the first adhesive layer 6, the solar power generation unit 2, the second adhesive layer 7 and the backplane protective plate 3 are exhausted through pre-exhausting and pre-heating, so that the first adhesive layer 6 and the second adhesive layer 7 are initially softened, so that the various components are initially bonded to form an in-process product.

After that, the gases among the light-transmitting front plate 1, the first adhesive layer 6, the solar power generation unit 2, the second adhesive layer 7 and the backplane protective plate 3 are further exhausted through exhausting and heating the in-process product, so that the first adhesive layer 6 and the second adhesive layer 7 are softened, and the adhesion stress thereof is increased again, so that the in-process product is formed as a power generation mechanism with stable structure.

Before sequentially laminating the light-transmitting front plate 1, the first adhesive layer 6, the solar power generation unit 2, the second adhesive layer 7, and the backplane protective plate 3, two bus bars 203 may be electrically connected to the anode and the cathode of the solar cell 202 by a method such as welding or bonding, so that the bus bars 203 is electrically connected to the solar cell 202.

In some embodiments of the present disclosure, there are various methods to perform pre-exhausting and exhausting processes, on the premise of easy realization and good exhausting effect, the examples are given as followings.

The pre-exhausting includes the first pressurized operation and/or the first vacuum pumping operation on the light-transmitting front plate 1, the solar power generation unit 2, and the backplane protective plate 3, which are sequentially stacked together.

Exemplary, the above operation may be the first pressurized operation and/or the first vacuum pumping operation on the light-transmitting front plate 1, the first adhesive layer 6, the solar power generation unit 2, the second adhesive layer 7 and the backplane protective plate 3, which are sequentially stacked together.

The exhausting includes the second pressurized operation and/or the second vacuum pumping operation on the in-process product.

That is, the pre-exhausting includes only the first pressurized operation, or, only the first vacuum pumping operation, or, the first pressurized operation and the first vacuum pumping operation at the same time.

The exhausting includes only the second pressurized operation on the in-process product, or, only the second vacuum pumping operation to the in-process product, or, the second pressurized operation and the second vacuum pumping operation on the in-process product at the same time.

Considering that during exhausting, the residual gas in the in-process product after pre-exhausting can be completely discharged. As an example, a pressure of the first pressurized operation is smaller than a pressure of the second pressurized operation, a suction force corresponding to the first vacuum pumping operation is smaller than a suction force corresponding to the second pressurized operation.

During the pre-heating and heating processes, considering the benefit of exhausting, and the well-bounded between the first adhesive layer 6 and the light-transmitting front plate 1, between the first adhesive layer 6 and the solar power generation unit 2, between the second adhesive layer 7 and the solar power generation unit 2, and between the second adhesive layer 7 and the backplane protective plate 3, a pre-heating temperature may be lower than a heating temperature.

In order to more clearly illustrate the preparation process of the power generation mechanism provided by some embodiments of the present disclosure, three examples are exemplary provided:

As a first example, the light-transmitting front plate 1, the solar power generation unit 2 and backplane protective plate 3, which are sequentially stacked together, are performed a first prepressing, pre-heating, a second prepressing to form an in-process product sequentially. It will be noted that, a pressure of the first prepressing may be smaller than a pressure of the second prepressing, so that the most gases among the light-transmitting front plate 1, the solar power generation unit 2 and the backplane protective plate 3 are discharged. When the light-transmitting front plate 1 is connected to the solar power generation unit 2 through the first adhesive layer 6, and the solar power generation unit 2 is connected to the backplane protective plate 3 through the second adhesive layer 7, most gases among the light-transmitting front plate 1, the first adhesive layer 6, the solar power generation unit 2, the second adhesive layer 7 and the backplane protective plate 3 are discharged by performing the first prepressing. Then, the first adhesive layer 6 and the second adhesive layer 7 are softened by pre-heating, so that the light-transmitting front plate 1, the first adhesive layer 6, the solar power generating unit 2, the second adhesive layer 7 and the back protective plate 3 are initially bonded.

The gases among the initial bonded light-transmitting front plate 1, the first adhesive layer 6, the solar power generation unit 2, the second adhesive layer 7 and the backing plate protective plate 3 are discharged by the second prepressing.

Specifically, the first prepressing, the pre-heating and the second prepressing may be performed by a roller press. The roller press includes a first roller press mechanism, a heating mechanism, a second roller press mechanism.

As a second example, the light-transmitting front plate 1, the solar power generation unit 2 and the backplane protective plate 3, which are sequentially stacked together, are performed vacuum pumping and pre-heating to form the in-process product.

When the light-transmitting front plate 1 is connected to the solar power generation unit 2 through the first adhesive layer 6, and the solar power generation unit 2 is connected to the backplane protective plate 3 through the second adhesive layer 7, the gases among the light-transmitting front plate 1, the first adhesive layer 6, the solar power generation unit 2, the second adhesive layer 7 and the backplane protective plate 3 can be efficiently discharged by vacuum pumping.

The vacuum pumping and pre-heating may be performed at the same time, or the vacuum pumping may be performed firstly and then the pre-heating is performed.

Specifically, the pre-exhausting and pre-heating can be performed by using a vacuum laminating machine.

As a third example, the light-transmitting front plate 1, the solar power generation unit 2 and the backplane protective plate 3, which are sequentially stacked together, are performed the prepressing and pre-heating to form the in-process product.

When the light-transmitting front plate 1 is connected to the solar power generation unit 2 through the first adhesive layer 6, and the solar power generation unit 2 is connected to the backplane protective plate 3 through the second adhesive layer 7, the pre-exhausting can be implemented by prepress, and the first adhesive layer 6 and the second adhesive layer 7 can be softened by the pre-heating, so that the light-transmitting front plate 1, the first adhesive layer 6, the solar power generation unit 2, the second adhesive layer 7 and the backplane protective plate 3 are initially bonded to form the in-process product.

The prepressing and pre-heating may be performed at the same time, or the prepressing may be performed firstly and then the pre-heating is performed.

Specially, pre-heating and prepressing can be performed by using a pre-heating prepressing machine, a laminating machine, a prepressing box etc.

As an example, the pre-heating temperature is 120∼160 °C, such as 120 °C, 130 °C, 140 °C, 150 °C, or 160 °C etc.

The prepressing pressure is 0.02∼1 MPa, such as 0.2 MPa, 0.3 MPa, 0.4 MPa, 0.5 MPa, 0.6 MPa, 0.7 MPa, 0.8 MPa, 0.9 MPa or 1 MPa etc.

Considering that the gases in the in-process product can be completely discharged, or trace gases are remained, the exhausting can be performed in a method of a pressurized operation.

Specially, the in-process product can be exhausted and heated by a high temperature kettle.

As an example, the heating temperature is 120 ∼140 °C, such as 120 °C, 130 °C or 140 °C etc.

The pressure of pressurized operation is 0.9∼1.3 MPa, such as 0.9 MPa, 1 MPa, 1.1 MPa, 1.2 MPa or 1.3 MPa etc.

Considering of preventing impurities, such as external moisture and dust, from entering into the area between the transparent front plate 1 and the backplane protective plate 3 to affect the power generation performance of the solar power generation unit 2, before laminating, the method provided by some embodiments of the present disclosure further includes the following steps:
An insulation sealing layer 5 is disposed between the light-transmitting front plate 1 and the solar power generation unit 2.

It will be noted that, in the process of preparing the power generation mechanism, there are gaps for exhausting among the light-transmitting front plate 1, the backplane protective plate 3 and the insulation sealing layer 5.

Specially, in the process of laminating the light-transmitting front plate 1, the first adhesive layer 6, the solar power generation unit 2, the second adhesive layer 7 and the backplane protective plate 3, the insulation sealing layer 5 may be provided on the light-transmitting front plate 1 or the backplane protective plate 3, or the insulation sealing layer 5 is formed by coating a liquid insulation sealing glue, or, after laminating the light-transmitting front plate 1, the first adhesive layer 6, the solar power generation unit 2, the second adhesive layer 7, and the backplane protective plate 3, the liquid insulation sealing glue is coated between the light-transmitting front plate 1 and the backplane protective plate 3 to form the insulation sealing layer 5,.

In another aspect, the embodiments of the present disclosure provide a power generation apparatus, the power generation apparatus includes at least one of the power generation mechanisms as mentioned above.

The power generation apparatus may be applied to different fields, such as the architecture field, automotive field etc.

Specially, the power generation apparatus can be used as a power generation laminated glass in a building. The power generation apparatus can be further applied to an automobile, high-speed rail etc.

In the description of the above embodiments, specific features, structures, materials or features can be combined in any suitable manner in any one or more embodiments or examples.

The above description is only illustrative embodiments of the present disclosure, and is not intended to limit the scope of the disclosure. Any modifications, equivalent transformations, improvements and a like, which are included in the spirit and principles of the present disclosure, should be included in the protection scope of the present disclosure.

## Claims

1. A power generation mechanism comprising: a light-transmitting front plate (1), a solar power generation unit (2) and a backplane protective plate (3), which are sequentially stacked together, wherein, the solar power generation unit (2) comprises:
a reinforced substrate (201); and
a solar cell (202) disposed on the reinforced substrate (201).

2. The power generation mechanism according to claim 1, wherein,
the solar cell (202) is embedded into the reinforced substrate (201);or,
the solar cell (202) is disposed on a surface of the reinforced substrate (201).

3. The power generation mechanism according to claim 2, wherein, on a condition that the solar cell (202) is embedded into the reinforced substrate (201), a surface of the solar cell (202) is flush with a surface of the reinforced substrate (201).

4. The power generation mechanism according to claim 1, wherein, a side surface of the reinforced substrate (201) facing the light-transmitting front plate (1) and a side surface of the reinforced substrate (201) facing the backplane protective plate (3) are both provided with the solar cell (202), and the backplane protective plate (3) is a light-transmitting backplane.

5. The power generation mechanism according to any one of claims 1∼3, wherein, the power generation mechanism further comprises an insulation antireflection film disposed on the light-transmitting front plate (1).

6. The power generation mechanism according to claim 4, wherein, the power generation mechanism further comprises an insulation antireflection film disposed on the light-transmitting front plate (1) and/or the light-transmitting backplane (3).

7. The power generation mechanism according to any one of claims 1∼4, wherein, the power generation mechanism further comprises an insulation sealing layer (5) disposed between the light-transmitting front plate (1) and the solar power generation unit (2).

8. The power generation mechanism according to any one of claims 1∼5, wherein, the power generation mechanism further comprises:
a first adhesive layer (6) disposed between the light-transmitting front plate (1) and the solar power generation unit (2);
and/or,
a second adhesive layer (7) disposed between the backplane protective plate (3) and the solar power generation unit (2); wherein,
the first adhesive layer (6) is a colored adhesive film, and the light-transmitting front plate (1) is a transparent front plate.

9. The power generation mechanism according to any one of claims 1∼5, wherein, the light-transmitting front plate (1) is a colored light-transmitting front plate;
or,
a color film layer (70) is provided on a plate surface of the light-transmitting front plate (1).

10. The power generation mechanism according to any one of claims 1∼5, wherein,
a thickness of the light-transmitting front plate (1) and a thickness of the backplane protective plate (3) are both larger than a thickness of the reinforced substrate (201); and/or
an intensity of the light-transmitting front plate (1) and an intensity of the backplane protective plate (3) are both greater than an intensity of the reinforced substrate (201).

11. A method for manufacturing the power generation mechanism according to any one of claims 1∼10, the method comprising:
laminating a light-transmitting front plate (1), a solar power generation unit (2) and a backplane protective plate (3), which are sequentially stacked together, to form the power generation mechanism.

12. The method according to claim 11, wherein, laminating the light-transmitting front plate (1), the solar power generation unit (2) and the backplane protective plate (3), which are sequentially stacked together, to form the power generation mechanism, comprises:
sequentially stacking the light-transmitting front plate (1), a first adhesive layer (6), the solar power generation unit (2), a second adhesive layer (7) and the backplane protective plate (3);
pre-exhausting and pre-heating the light-transmitting front plate (1), the first adhesive layer (6), the solar power generation unit (2), the second adhesive layer (7) and the backplane protective plate (3), which have been sequentially stacked together, to form an in-process product;
exhausting and heating the in-process product to form the power generation mechanism.

13. The method according to claim 12, wherein,
the pre-exhausting comprises a first pressurized operation and/or a first vacuum pumping operation.
the exhausting comprises: a second pressurized operation, and/or a second vacuum pumping operation, wherein,
a pressure of the first pressurized operation is smaller than a pressure of the second pressurized operation;
a suction force corresponding to the first vacuum pumping operation is smaller than a suction force corresponding to the second vacuum pumping operation.

14. The method according to any one of claims 11∼13, wherein, before laminating the light-transmitting front plate (1), the solar power generation unit (2) and the backplane protective plate (3), which are sequentially stacked together, the method further comprises:
providing an insulation sealing layer (5) between the light-transmitting front plate (1) and the solar power generation unit (2).

15. A power generation apparatus comprising at least one power generation mechanism according to any one of claims 1∼14 or at least one the power generation mechanism manufactured by the method according to any one of claims 15∼19.
